# EUROPEAN PATENT SPECIFICATION

(11) **EP 1 852 900 B1**
(45) Date of publication and mention of the grant of the patent: **21.09.2011**
(21) Application number: 06714084.8
(22) Date of filing: 20.02.2006
(51) Int. Cl.: H01L 21/304, B24B 37/04

(54) **CARRIER FOR DOUBLE SIDE POLISHING MACHINE AND DOUBLE SIDE POLISHING MACHINE EMPLOYING IT, AND DOUBLE SIDE POLISHING METHOD**
TRÄGER FÜR EINE DOPPELSEITIGE POLIERMASCHINE UND DIESEN VERWENDENDE DOPPELSEITIGE POLIERMASCHINE UND VERFAHREN ZUM DOPPELSEITIGEN POLIEREN
PORTEUR POUR MACHINE DE POLISSAGE DOUBLE FACE, MACHINE DE POLISSAGE DOUBLE FACE UTILISANT LE DIT PORTEUR ET PROCEDE DE POLISSAGE DOUBLE FACE

(30) Priority: 25.02.2005 JP 2005049933
(43) Date of publication of application: 07.11.2007
(73) Proprietor: Shin-Etsu Handotai Co., Ltd., Tokyo (JP)
(72) Inventor: UENO, Junichi Shirakawa R&D Center Shin-Etsu, Nishigo-mura, Nishishirakawa-gun, Fukush (JP)
(74) Representative: Wibbelmann, Jobst
(86) International application number: PCT/JP2006/302943
(87) International publication number: WO 2006/090661

(56) References cited:
- DE-A1- 10 247 200
- JP-A- 4 026 117
- JP-A- 11 129 156
- JP-A- 2000 127 030
- JP-A- 2001 338 901
- JP-A- 2002 018 707
- JP-A- 2006 026 760
- US-A1- 2002 049 026

## Description

### Technical Field

The present invention relates to a carrier for a double-side polishing apparatus which, in a double-side polishing apparatus, holds a wafer when the wafer is polished.

### Background Art

When both sides of, for example, a semiconductor wafer are polished, the semiconductor wafer is held with a carrier during being polished. A holding hole is formed in the carrier, then the semiconductor wafer is held in the holding hole and sandwiched between upper and lower turn tables to which polishing pads are attached, then, the upper and lower turn tables are rotated with polishing surfaces supplied with a polishing agent to polish both sides of the semiconductor wafer at the same time.

As a carrier having conventionally been used in this double-side polishing step, a carrier made of glass-epoxy material, uncoated SUS material or resin-coated SUS material has been the mainstream.

However, as for a carrier made of glass-epoxy material, abrasion degree during polishing is high, so that the life of the carrier is short and costs run up. Moreover, the carrier made of glass-epoxy material requires much time to start up, so that the productivity is inferior.

And, as for a carrier made of uncoated SUS material, there is the danger that the semiconductor wafer is contaminated by Fe or Ni contained in SUS material.

Next, as for a carrier made of resin-coated SUS material, abrasion degree of resin during polishing is also high, so that the life of the carrier is short, and contamination of a semiconductor wafer is caused. Moreover, there is a problem that sag is apt to be generated in a peripheral portion of the semiconductor wafer after being polished.

In order to improve the carrier made of resin-coated SUS material, there is disclosed a carrier in which resin layers on a front surface and a back surface are combined through small holes formed in SUS material, which cannot provide a decisive solution to the above-mentioned problem (see Japanese Patent Laid-Open (kokai) No.9-207064).

In DE 10 247 200 A1, there is disclosed a carrier for a double-side polishing apparatus in accordance with the preamble of claim 1.

### Disclosure of the Invention

The present invention was conceived in view of the above problems. The object of the present invention is to provide a carrier in which the strength of the carrier itself is high, and at the same time, contamination of a wafer such as a silicon wafer by impurities is suppressed, and sag in a peripheral portion of the wafer after being polished is suppressed.

According to the present invention, there is provided a carrier for a double-side polishing apparatus in which, in a double-side polishing apparatus, the carrier is set between upper and lower turn tables to which polishing pads are attached, and a holding hole to hold a wafer sandwiched between the upper and lower turn tables in polishing is formed in the carrier, wherein the carrier is one made of titanium material. Whose surface is coated with either a titanium nitride film or a DLC (Diamond-Like Carbon) film.

As described above, in a double-side polishing apparatus, when a carrier to hold a wafer is made of titanium, the carrier has high hardness and abrasion degree during polishing is low as compared with resin, so that the life of the carrier becomes lengthened. Moreover, titanium itself has low diffusion coefficient in a semiconductor wafer such as a silicon wafer, so that it is hardly put a question as an impurity. Further, metal impurities having high diffusion coefficient such as Fe do not exist in titanium. Therefore, contamination of the wafer by metal impurities can be suppressed. Moreover, when the wafer is polished with being held with this carrier, a surface of the carrier need not be coated with a thick resin layer, so that there can be obtained a wafer having high flatness in which sag is not generated in a peripheral portion.

As a surface of the carrier is coated with either a titanium nitride film or a DLC film as described above, the hardness becomes higher, so that the carrier becomes hardly scratched. Further, a foreign body's falling into a polishing slurry can be also suppressed. Therefore, it becomes possible that the life of the carrier is lengthened and contamination of a wafer is suppressed. Moreover, a scratch failure of a wafer can be effectively prevented.

Furthermore, it is preferable that a thickness of the film is in the range of 0.3 µm to 5 µm.

When a thickness of the film coating the surface of the carrier is in the range of 0.3 µm to 5 µm as described above, the thickness is enough to protect the carrier, for titanium nitride and DLC have high hardness. Further, the thickness is small enough as compared with resin coat, so that the film does not become an obstacle to obtaining a wafer in which sag is not generated in a peripheral portion.

Moreover, it is possible that the wafer sandwiched between the upper and lower turn tables is a semiconductor wafer.

As described above, it is possible that the wafer sandwiched between the upper and lower turn tables is a semiconductor wafer, thereby there can be obtained a semiconductor wafer in which contamination of the wafer by metal impurities is suppressed, the wafer has high flatness, and sag is not generated in a peripheral portion.

And, it is preferable that a double-side polishing apparatus comprises, at least, the carrier for a double-side polishing apparatus.

When a double-side polishing apparatus comprises the carrier for a double-side polishing apparatus according to the present invention as described above, the film coating a surface of the carrier has high hardness, so that abrasion degree during polishing is low, generation of scratches or breakages of the carrier can be reduced and the life of the carrier can be lengthened. Moreover, when, for example, a semiconductor wafer is polished, there can be provided a semiconductor wafer by polishing in which contamination of the wafer by metal impurities through the carrier is suppressed and sag in a peripheral portion is not generated.

Further, it is preferable that the carrier is set between the upper and lower turn tables to which the polishing pads are attached, and the wafer is held in the holding hole formed in the carrier, then both sides of the wafer are polished with the wafer sandwiched between the upper and lower turn tables.

When the wafer is held in the holding hole formed in the carrier for a double-side polishing apparatus according to the present invention, then both sides of the wafer are polished with the wafer sandwiched between the upper and lower turn tables as described above, as impurities having high diffusion coefficient such as Fe do not exist in titanium which is a material for the carrier, contamination of the wafer can be suppressed. Further, as a surface of the carrier need not be coated with a thick resin, the carrier has high flatness, which makes it possible that a wafer in which sag is not generated in a peripheral portion is obtained.

Furthermore, as the carrier has high hardness, abrasion is suppressed to lengthen the life of the carrier, so that costs are reduced and both sides of the wafer can be efficiently polished.

A carrier for a double-side polishing apparatus to hold a wafer sandwiched between the upper and lower turn tables to which polishing pads are attached in a double-side polishing apparatus, wherein the carrier is made of titanium according to the present invention has high hardness and abrasion degree during polishing is low as compared with resin, so that the life of the carrier becomes improved, further, as metal impurities having high diffusion coefficient such as Fe do not exist in titanium, metal contamination of the wafer can be suppressed. Moreover, as thick resin coat is needless, there can be obtained a wafer having high flatness in which sag is not generated in a peripheral portion.

### Brief Explanation of the Drawings

Fig. 1 is a longitudinal sectional view showing an example of a double-side polishing apparatus comprising a carrier for a double-side polishing apparatus according to the present invention.
Fig. 2 is an inner structure view of a double-side polishing apparatus in plane view.
Fig. 3 is a schematic view showing an example of a carrier according to the present invention.
Fig. 4 (A) is an explanatory view showing a situation of a semiconductor wafer being held with a carrier made of uncoated titanium not according to the present invention. Fig. 4 (B) is an explanatory view showing a situation of a semiconductor wafer being held with a carrier coated according to the present invention. Fig. 4 (C) is an explanatory view showing a situation of a semiconductor wafer being held with a conventional resin-coated carrier.
Fig. 5 is results of analysis of Examples 3, 4 and Comparative examples 2, 3.
Fig. 6 (A) is measurement results of Example 5. Fig. 6 (B) is measurement results of Comparative example 4.
Fig. 7 is data comparing measurement results of Examples 6 and 7.

### Best Mode for Carrying out the Invention

Hereinafter, the present invention will be explained. However, the present invention is not limited thereto.

A carrier made of glass-epoxy material or resin-coated SUS material has been particularly used as a conventional carrier for a double-side polishing apparatus.

However, the surface hardness of such a carrier is low and abrasion degree during polishing is high, so that there have been problems that the life of the carrier is shortened and costs run up. Moreover, there is the danger that, by polishing, a semiconductor wafer is contaminated by metal impurities having high diffusion coefficient such as Fe or Ni, for example, within the carrier. Furthermore, thick resin as thick as 100 to 200 µm is required for a surface, which obliges the force to press a polishing pad around the wafer to decrease, so that there has been caused a problem in relation to flatness of a semiconductor wafer after being polished that sag is generated in a peripheral portion.

Then, the present inventors have invented a carrier for a double-side polishing apparatus in which, in a double-side polishing apparatus, the carrier is set between upper and lower turn tables to which polishing pads are attached, and a holding hole to hold a wafer sandwiched between the upper and lower turn tables at the time of polishing is formed in the carrier, wherein the carrier is made of titanium.

Such a carrier for a double-side polishing apparatus has sufficiently high hardness and abrasion degree during polishing is low as compared with a carrier whose surface is resin-coated, so that the life of the carrier becomes improved. Moreover, metal impurities having high diffusion coefficient such as Fe do not exist in such a carrier, so that contamination of the wafer by metal impurities can be suppressed. Furthermore, the present inventors have found that as the carrier need not be coated with thick resin, sag generated in a peripheral portion of the wafer after being polished can be suppressed at the time of polishing, then, they have completed the present invention.

Hereinafter, embodiments of the present invention will be explained with Figures.

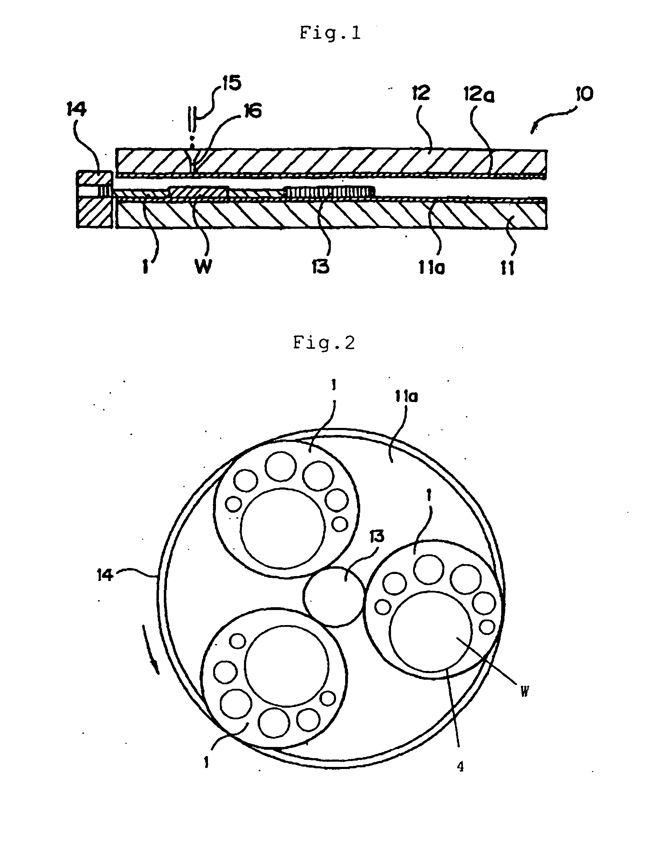

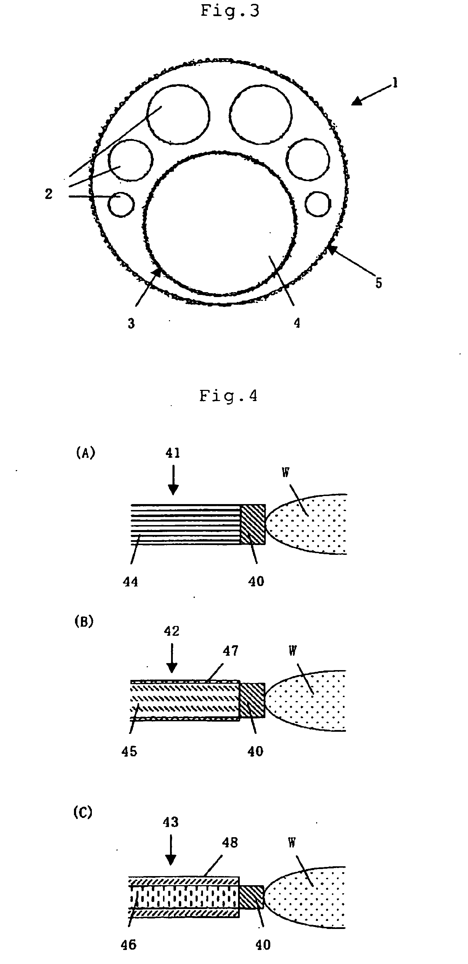

Here, Fig. 1 is a longitudinal sectional view showing a double-side polishing apparatus comprising a carrier for a double-side polishing apparatus according to the present invention, Fig. 2 is an inner structure view of a double-side polishing apparatus in plane view, Fig. 3 is a schematic view of a carrier for a double-side polishing apparatus according to the present invention, and Fig. 4 is explanatory views showing situations of semiconductor wafers being held with a conventional carrier and carriers according to the present invention.

The present invention relates to improvements of a carrier to hold a wafer in a double-side polishing apparatus in which both sides of the wafer are polished at the same time. First, an outline of the double-side polishing apparatus will be explained with Figs. 1 and 2.

A wafer applicable to a carrier according to the present invention is not particularly limited. For example, a wafer of silicon, quartz, GaAs or the like is applicable. Here, a semiconductor wafer such as a silicon wafer is given as an example for explanation.

A double-side polishing apparatus 10 comprising a carrier 1 for a double-side polishing apparatus made of titanium according to the present invention has a lower turn table 11 and an upper turn table 12 set above and below so that the two turn tables face each other. Polishing pads 11a and 12a are respectively attached to facing surfaces of polishing turn tables 11 and 12. Further, the upper side of the upper turn table 12 is provided with a nozzle 15 to supply a polishing slurry, and upper turn table 12 is provided with a penetrating hole 16. Then, between the upper turn table 12 and the lower turn table 11, a sun gear 13 is set in the central part, and an internal gear 14 is set in the peripheral part. A semiconductor wafer W is held with a holding hole 4 in the carrier 1 and sandwiched between the upper turn table 12 and the lower turn table 11.

Each tooth of the sun gear 13 and the internal gear 14 meshes with an external tooth of the carrier 1. In accordance with the upper turn table 12 and the lower turn table 11 rotated by a driving source unshown in Figures, the carrier 1 revolves around the sun gear 13 while rotating. Here, the semiconductor wafer W is held with the holding hole 4 in the carrier 1, and both sides of the wafer are polished at the same time by the upper and lower polishing pads 11a and 12a. At the time of polishing, a polishing slurry is supplied from the nozzle 15 through the penetrating hole 16.

With such a double-side polishing apparatus 10 comprising the carrier for a double-side polishing apparatus according to the present invention, the carrier 1 has high hardness, so that abrasion degree during polishing is low, scratches or breakages of the carrier can be reduced, the life of the carrier can be lengthened, and costs can be reduced. Moreover, when polishing is carried out, a semiconductor wafer W can be polished so that contamination of the wafer by metal impurities from the carrier 1 is suppressed, there can be obtained a semiconductor wafer in which sag in a peripheral portion is suppressed. Particularly, in recent years, as a diameter of a semiconductor wafer such as a silicon wafer enlarges, a carrier also enlarges and the life of the carrier becomes still shorter. Therefore, the present invention is effective for application to a polishing apparatus for a wafer with a large diameter of 200 mm or more, particularly 300 mm or more.

Next, a carrier for a double-side polishing apparatus according to the present invention will be explained using Fig. 3.

The holding hole 4 is made in the carrier 1, and a semiconductor-wafer holding part 3 to protect a wafer edge from scratches is provided along an internal circumference of the holding hole 4. Moreover, polishing-agent hole 2 through which the polishing agent runs is made in the carrier 1 apart from the holding hole 4, and external teeth 5 are provided in a peripheral portion of the carrier.

The main material of the carrier according to the present invention is titanium, so that the carrier surface has high hardness as compared with a conventional carrier made of, for example, resin-coated SUS material, and at the same time, impurities having high diffusion coefficient such as Fe or Ni do not exist. Therefore, scratches or breakages of the carrier can be reduced and the life of the carrier can be lengthened. Moreover, metal contamination of the semiconductor wafer W can be suppressed.

Furthermore, as a surface of the carrier 1 is coated with either a titanium nitride film or a DLC film, it becomes possible that the surface hardness is made still higher and the life of the carrier is still lengthened. A method for forming such films is not particularly limited. For example, the films may be deposited by CVD method, or formed by a method in which the carrier surface is made to react with nitrogen by heat treatment in a nitrogen atmosphere. Moreover, the films may be formed by sputtering. These forming methods can produce the films having uniform surfaces with little film unevenness.

The hardness of SUS, a material for a conventional carrier, is 420 Hv, while the hardness of Ti, a material for the carrier according to the present invention, is 220 Hv. Namely, Ti has low hardness as compared with SUS, therefore, it has not conventionally been thought that Ti can be used as a material for a carrier. However, as described above, uncoated SUS material causes fatal metal contamination of the semiconductor wafer W, and in practice, it is essential that SUS material be coated with resin in order to suppress metal contamination. For that reason, a surface of the carrier 1 made of titanium according to the present invention has higher hardness than the conventional carrier whose surface is resin-coated. Therefore, the life of the carrier can be lengthened. Furthermore, the hardness of titanium nitride and DLC is respectively 2200 Hv and 3000 to 5000 Hv. Accordingly, by coating the carrier surface with either a titanium nitride film or a DLC film, the carrier becomes possible to have still higher hardness and still more lengthened life.

Moreover, as the carrier is coated with the titanium nitride film or the DLC film, scratch failure of a wafer can be effectively prevented from being generated.

It seems that is because these films with high hardness can protect a carrier body and prevent the carrier body from being shaved during polishing and being mixed with a polishing slurry to cause damage to the wafer. Further, also in the case where, when the carrier thickness is processed by lapping, a lapping agent attaches to the carrier surface as pollution and the lapping agent cannot be removed even if the carrier is subjected to cleaning, it seems that scratches of the wafer are prevented from being generated, for the carrier surface is coated together with the pollution.

On the other hand, the holding part 3 of the periphery of the holding hole 4 is made of, for example, aramid resin, and that is provided in order to protect a chamfered portion of the semiconductor wafer W from being damaged when holding the semiconductor wafer W.

And, the polishing-agent hole 2 is a hole for a polishing slurry which is supplied at the time of polishing to run through. A polishing slurry is evenly supplied to also a polishing surface of the underside through the hole.

As described above, the external teeth 5 mesh with the sun gear 13 and the internal gear 14, and the carrier 1 revolves around the sun gear 13 while rotating at the time of polishing.

Next, it will be explained using Fig. 4 that a carrier according to the present invention is effective for preventing sag from being generated in a peripheral portion of the wafer at the time of polishing. Fig. 4 shows situations of semiconductor wafers being held respectively with (A) a carrier made of uncoated titanium (not in accordance with the invention), (B) a carrier made of titanium whose surface is coated with either a titanium nitride film or a DLC film, and (C) a carrier made of SUS material whose surface is coated with resin. (B) is an explanatory view in which a carrier according to the present invention is used, and (C) is an explanatory view in which a conventional carrier is used.

Carriers 41, 42, 43 of (A), (B), (C) respectively have carrier bodies 44, 45, 46, and each carrier has a holding part 40. However, films 47, 48 are formed on surfaces of the carriers 42, 43 respectively. As described above, the carrier bodies 44 and 45 are made of titanium, and the carrier body 46 is made of SUS. Further, each holding part 40 is made of aramid resin, the film 47 is made of either titanium nitride or DLC, and the film 48 is made of resin such as polycarbonate.

As shown in Fig. 4(C), as for the conventional carrier, namely, the carrier 43 made of resin-coated SUS material, the film 48 requires the thickness of 100 to 200 µm, so that the carrier body 46 becomes thin correspondingly and a surface of the holding part 40 and that of the film 48 make a step. Accordingly, at the time of polishing, in the part directly under the holding part 40 holding a peripheral portion of the wafer, the polishing pads cannot be sufficiently pressed due to elasticity of the resin of the thick film 48. Namely, the retainer effect is reduced and the polishing pads near the holding part 40 become twisted to excessively polish the peripheral portion of the semiconductor wafer W, so that sag in the peripheral portion is generated.

Moreover, in the case where polishing is carried out with a carrier made of uncoated SUS material without resin-coated or a carrier in which the thickness of the film 48 is made small to remove a step that the film 48 and the polishing part 40 make in order to prevent the retainer effect from being reduced, the semiconductor wafer W is contaminated by metal and of no use.

On the other hand, as for the carrier 41 not according to the present invention, the body 44 is made of titanium that has higher hardness than resin, and the surface need not be coated with resin and the like, for contamination of the semiconductor wafer W is suppressed. Therefore, no step is generated as shown in Fig. 4(A), and the holding part 40 can have sufficient height, which makes it possible that the polishing pads near the holding part 40 can be sufficiently pressed. Accordingly, excessive polishing of the chamfered portion of the semiconductor wafer W is not caused, so that there can be obtained a wafer having high flatness in which sag in a peripheral portion after polishing is suppressed.

Moreover, as shown in Fig. 4(B), as for the carrier 42 according to the present invention, even if a surface of the carrier body 45 is coated with the film 47, almost no step is generated, for 0.3 to 5 µm is enough for the thickness of the film. Therefore, the retainer effect is hardly reduced, and an influence on sag in a peripheral portion of the semiconductor wafer after being polished is suppressed, so that there can be obtained the semiconductor wafer W having high flatness.

As described above, a double-side polishing method using the carrier 1 for a double-side polishing apparatus according to the present invention makes it possible that the life of the carrier is improved and the semiconductor wafer W of high quality in which metal contamination and sag in a peripheral portion are suppressed is efficiently obtained.

Moreover, although a carrier for a double-side polishing apparatus of a planetary type has been described above as an example, a carrier for a double-side polishing apparatus according to the present invention is not limited to the planetary type, and can be effectively used as a carrier for a double-side polishing apparatus of a swinging type.

Hereinafter, the present invention will be explained in further detail according to Examples and Comparative examples. However, the present invention is not limited thereto.

### (Examples 1 and 2, Comparative example 1)

First, each of the group of carriers according to the present invention and a conventional carrier was polished until the thickness becomes nonstandard, then elapsed time was measured. The measured carriers had such forms as shown in Fig. 3, and they were three in all, one was made of uncoated titanium material (thickness 778 µm : Example 1 not according to the present invention), one was made of titanium material whose surface was coated with a DLC film (thickness of titanium material 774 µm, thickness of the DLC film 2 µm : Example 2 according to the present invention), and one was made of SUS material whose surface was coated with resin (thickness of SUS material 598 µm, thickness of resin coat 90 µm : Comparative example 1).

It took 16000 minutes and 20800 minutes respectively in Examples 1 and 2, and 800 minutes in Comparative example 1.

As described above, it has been found that the carrier for a double-side polishing apparatus according to the present invention has high hardness, durability and the long life of the carrier, so that costs can be reduced.

### (Examples 3 and 4 not according to the present invention, Comparative examples 2 and 3)

Next, a silicon wafer with a diameter of 300 mm was prepared as a sample wafer. Then, this silicon wafer was held with a carrier, and both sides of the silicon wafer were polished for 60 minutes using such a double-side polishing apparatus as shown in Figs. 1 and 2.

Subsequently, the polished sample wafer was put in a bag, then a mixed solution of nitric acid and hydrofluoric acid was added in the bag and boiled, then impurities in a liquid in the bag were analyzed with ICP-MS.

A carrier made of uncoated titanium (Examples 3 and 4) and a carrier made of SUS whose surface was coated with resin (Comparative examples 2 and 3) were prepared as the carriers to hold the sample wafer, then the above-described experiment was carried out using the respective carriers.

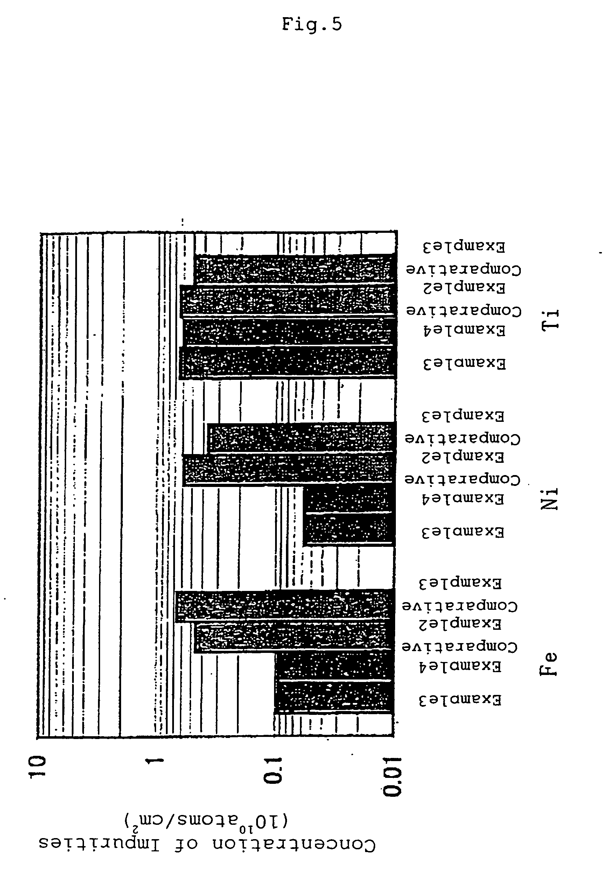

The results of the analysis in Examples 3, 4 and Comparative examples 2, 3 are shown in Fig. 5.

Fig. 5 shows that there is caused a great difference in concentration of Fe and Ni between Examples 3, 4 and Comparative examples 2, 3 in which the conventional carrier was used. Moreover, respective values of concentration of Fe and Ni in Examples and Comparative examples before polishing are the same as those in Examples after polishing. Thereby, it is found that, in Comparative examples, the sample wafers are contaminated by Fe and Ni within the carriers, and on the other hand, in Examples, the sample wafers are not contaminated.

Further, the concentration of Ti differs little between before and after polishing as to both Examples and Comparative examples.

As described above, it is found that a carrier made of titanium can suppress contamination of the semiconductor wafer by metal impurities.

### (Example 5, Comparative example 4)

Next, both sides of a sample wafer were polished using a carrier according to the present invention made of titanium, then, a shape of the polished sample wafer was measured (measuring instrument : Nanometro 300TT manufactured by Kuroda Precision Industries Ltd.), and GBIR, SFQR(max), SBIR(max) and a roll-off were measured (Example 5).

Further, both sides of a sample wafer were polished in the same manner as Example 5 using a conventional carrier made of resin-coated SUS material, then the measurements were carried out (Comparative example 4).

GBIR (global backside ideal range) refers, when a standard plane is prepared within a wafer surface with a back surface of the wafer set flat, to a difference between the maximum positional displacement and the minimum positional displacement against the standard plane.

Moreover, SFQR (site front least squares range) refers, when a plane in a site obtained by calculating data with the least squares method within a given site with a back surface of the wafer set flat is regarded as a standard plane, to a difference between the maximum positional displacement and the minimum positional displacement against the standard plane in regard to each site. (max) refers to the largest difference in all sites.

SBIR (site back ideal range) refers, when a back surface of the wafer is employed as a standard plane with it set flat, to a difference between the maximum value and the minimum value of surface heights from the standard plane in regard to each site. (max) refers to the largest difference in all sites in the same manner as SFQR.

And, a roll-off is sag in the outermost peripheral portion of a wafer, which refers to a difference between the maximum value and the minimum value of surface heights in regard to a central portion and a peripheral portion of the wafer with a back surface of the wafer set flat.

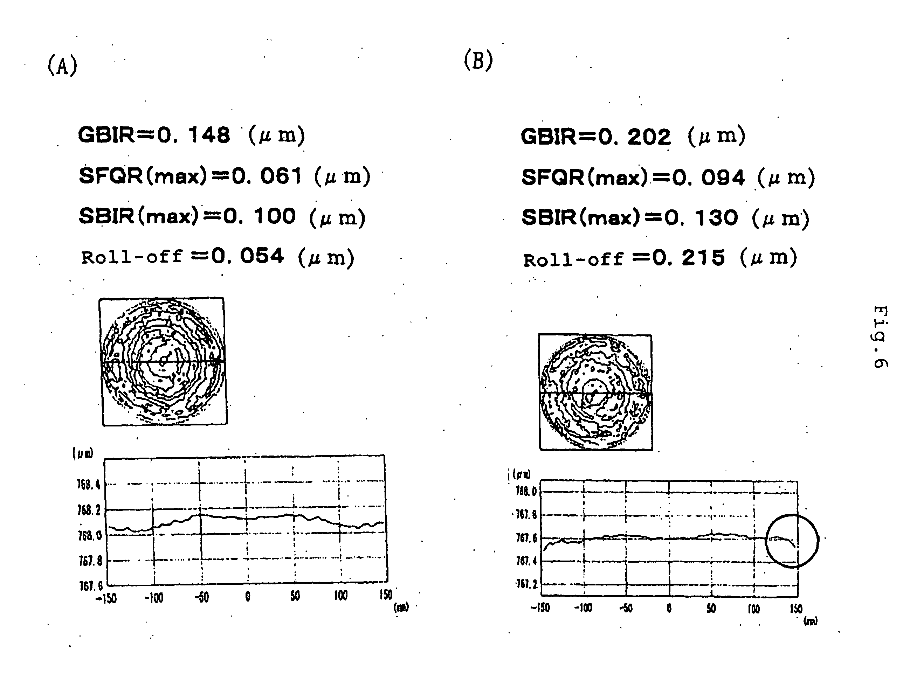

Fig. 6 (A) and (B) show the results of the measurements of Example 5 and Comparative example 4.

As shown here, Example 5 in which a carrier according to the present invention was used shows a small value in regard to each datum as compared with Comparative example 4 in which a conventional carrier was used. Therefore, the flatness in Example 5 is higher than in Comparative example 4. Particularly, the effect of preventing sag in a peripheral portion is high in Example 5. On the other hand, data of Comparative example 4 show a state of sag in the peripheral portion generated clearly (a circled part in Fig. 6 (B)).

In Comparative example 4, a surface of SUS material is coated with resin, so that a height of aramid resin of a wafer-holding part is smaller than that of the carrier according to the present invention, and a step is generated by a surface of a carrier and a surface of the holding part. In addition, the retainer effect is reduced under the influence of elasticity of resin on the carrier surface, so that polishing pads become twisted to excessively polish a peripheral portion of the sample wafer, and sag in the peripheral portion is generated.

As described above, when both sides of a wafer is polished using the carrier according to the present invention, there can be obtained a semiconductor wafer having high flatness in which sag in a peripheral portion is not generated.

### (Examples 6 and 7)

As a carrier to hold the sample wafer, a carrier made of uncoated titanium was prepared (Example 6 not according to the present invention), and a carrier made of titanium coated with a DLC film was prepared (Example 7 according to the present invention). Then both sides of 250 sample wafers were polished using a double-side polishing apparatus shown in Figs. 1 and 2 respectively.

The sample wafers after being polished were put into an apparatus for wafer backside inspection RXM-1227E (manufactured by Raytex Corporation), and the presence or absence of scratches on back surfaces of the wafers was checked by CCD image processing.

Here, when even one scratch was detected on a wafer in the above-described method, the wafer was determined as a scratch failure. (That does not necessarily mean a wafer failure, for a wafer can be reconditioned by being polished again.)

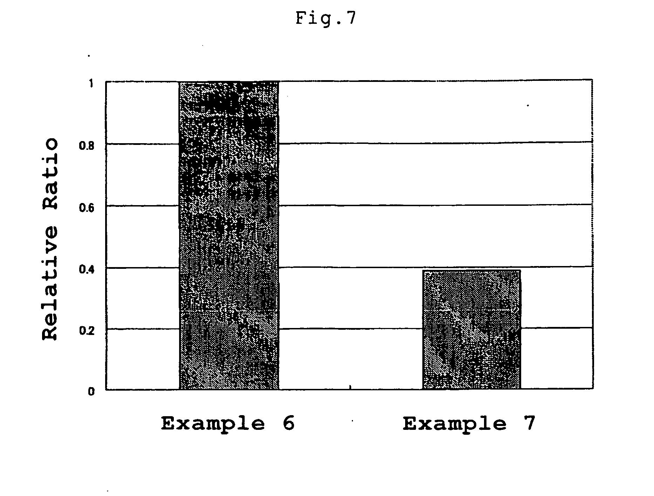

Fig. 7 shows a ratio of scratch failures on the back surfaces of the wafers in Examples 6 and 7 in a relative ratio.

Example 7 reveals that, when a carrier coated with a DLC film is used, scratches can be effectively prevented from being generated on a wafer, and there can be obtained a wafer of still higher quality.

Moreover, the present invention is not limited to the above-described embodiments. The above-described embodiments are mere examples, and those having the substantially same constitution as that described in the appended claims and providing the similar action and advantages are included in the scope of the present invention.

## Claims

1. A carrier (1, 42) for a double-side polishing apparatus in which, in a double-sid polishing apparatus, the carrier is set between upper and lower turn tables (11, 12) to which polishing pads (11a,12a) are attached, and a holding hole (4) to hold a wafer (W) sandwiched between the upper and lower turn tables in polishing is formed in the carrier,
**characterised in that** the carrier is one made of titanium material whose surface is coated with a titanium nitride film or one made of titanium material whose surface is coated with a diamond-like carbon (DLC) film.

2. The carrier for a double-side polishing apparatus according to claim 1, wherein a thickness of the film is in the range of 0.3 µm to 5 µm.

3. The carrier for a double-side polishing apparatus according to claim 1 or 2, wherein the wafer sandwiched between the upper and lower turn tables is a semiconductor wafer.

4. A double-side polishing apparatus comprising, at least, the carrier for a double-side polishing apparatus according to any one of claims 1-3.

5. A method for polishing both sides of a wafer, wherein the carrier according to any one of claims 1-3 is set between the upper and lower turn tables to which the polishing pads are attached, and the wafer is held in the holding hole formed in the carrier, then both sides of the wafer are polished with the wafer sandwiched between the upper and lower turn tables.

## Patentansprüche

1. Träger (1, 42) für eine doppelseitige Poliermaschine, in der, in einer doppelseitigen Poliermaschine, der Träger zwischen oberen und unteren Drehtellern (11, 12), an denen Polierpads (11a, 12a) angebracht sind, vorgesehen ist, und ein Halteloch (4), zum Halten eines zwischen den oberen und unteren Drehtellern angeordneten Wafers (W) beim Polieren, auf dem Träger gebildet ist,
**dadurch gekennzeichnet, dass** der Träger ein Träger aus Titanmaterial ist, dessen Oberfläche mit einem Titannitrid-Film beschichtet ist, oder ein Träger aus Titanmaterial ist, dessen Oberfläche mit einem diamantartigen Kohlenstoff (diamond like carbon, DLC)-Film beschichtet ist.

2. Träger für eine doppelseitige Poliermaschine nach Anspruch 1, wobei eine Dicke des Films in dem Bereich von 0,3 µm bis 5 µm liegt.

3. Träger für eine doppelseitige Poliermaschine nach Anspruch 1 oder 2, wobei der zwischen den oberen und unteren Drehtellern angeordnete Wafer ein Halbleiterwafer ist.

4. Doppelseitige Poliermaschine, umfassend mindestens einen Träger für eine doppelseitige Poliermaschine nach einem der Ansprüche 1-3.

5. Verfahren zum Polieren beider Seiten eines Wafers, wobei der Träger nach einem der Ansprüche 1-3 zwischen den oberen und unteren Drehtellern, an denen die Polierpads angebracht sind, vorgesehen ist, und der Wafer in einem Halteloch, das auf dem Träger gebildet ist, gehalten wird, dann Polieren des zwischen den oberen und unteren Drehtellern angeordneten Wafers auf beiden Seiten.

## Revendications

1. Support (1, 42) pour un appareil de polissage double face dans lequel, dans un appareil de polissage double face, le support est établi entre des plaques tournantes supérieure et inférieure (11, 12) sur lesquelles des tampons de polissage (11a, 12a) sont fixés, et un trou de maintien (4) pour maintenir une plaquette (W) prise en sandwich entre les plaques tournantes supérieure et inférieure en polissant est formé dans le support,
**caractérisé en ce que** le support est l'un composé d'un matériau en titane dont la surface est revêtue d'un film de nitrure de titane ou l'un composé d'un matériau en titane dont la surface est revêtue d'un film de carbone sous forme de diamant amorphe (DLC).

2. Support pour un appareil de polissage double face selon la revendication 1, dans lequel une épaisseur du film se situe dans la plage allant de 0,3 µm à 5 µm.

3. Support pour un appareil de polissage double face selon la revendication 1 ou 2, dans lequel la plaquette prise en sandwich entre les plaques tournantes supérieure et inférieure est une plaquette en semi-conducteur.

4. Appareil de polissage double face comprenant au moins le support pour un appareil de polissage double face selon l'une quelconque des revendications 1 à 3.

5. Procédé de polissage des deux côtés d'une plaquette, dans lequel le support selon l'une quelconque des revendications 1 à 3 est fixé entre les plaques tournantes supérieure et inférieure sur lesquelles les tampons de polissage sont fixés, et la plaquette est maintenue dans le trou de maintien formé dans le support, ainsi les deux côtés de la plaquette sont polis avec la plaquette prise en sandwich entre les plaques tournantes supérieure et inférieure.
